# EUROPÄISCHE PATENTANMELDUNG

(11) **EP 4 354 495 A2**
(43) Veröffentlichungstag der Anmeldung: **17.04.2024**
(21) Anmeldenummer: 24159953.9
(22) Anmeldetag: 29.06.2020
(51) Int. Cl.: H01L 21/683

(54) **VERFAHREN UND VORRICHTUNG ZUM BONDEN VON SUBSTRATEN**

(62) Teilanmeldung aus: 20735550.4
(71) Anmelder: EV Group E. Thallner GmbH, 4782 St. Florian am Inn (AT)
(72) Erfinder: Zinner, Dominik, 4782 St. Florian am Inn (AT); Wagenleitner, Thomas, 4782 St. Florian am Inn (AT); Süss, Jürgen Markus, 4782 St. Florian am Inn (AT); Plach, Thomas, 4782 St. Florian am Inn (AT); Mallinger, Jürgen, 4782 St. Florian am Inn (AT)
(74) Vertreter: Schneider, Sascha

(57) **Zusammenfassung**

Vorgeschlagen wird ein Substrathalter (1',1",1‴) zum Krümmen eines Substrats (7), aufweisend
- eine Fixierplatte (3) zur Befestigung des Substrats (7),
- Krümmungsmittel (6, 6', 6") zur Krümmung der Fixierplatte (3), wobei die Fixierplatte (3) derart ausgebildet ist, dass die Krümmung des Substrats (7) gezielt einstellbar ist, sowie ein korrespondierendes Verfahren.

## Beschreibung

Die Erfindung beschreibt einen Substrathalter, eine Vorrichtung und ein Verfahren zum Bonden zweier Substrate gemäß den nebengeordneten Ansprüchen.

Der Stand der Technik zeigt eine große Anzahl unterschiedlicher Substrathalter auf. Insbesondere im Fusionsbonden werden die Substrathalter immer komplizierter und ausgefeilter, um den immer höher werdenden Anforderungen des Bondvorgangs gerecht zu werden. In der Druckschrift WO2012083978A1 wurde ein Substrathalter erwähnt, der lokale und/oder globale Verzerrungen durch die aktive Steuerung mittels Thermo-, Piezo- oder Fluidelemente kompensieren kann. Der Substrathalter der Druckschrift WO2013023708A1 zeigt Möglichkeiten auf, um die Rückseite eines Substrats möglichst nicht zu kontaminieren, sowie ein Verfahren zum Loslösen des Substrats durch eine gezielte Steuerung der Fixierelemente. Die Druckschrift WO2017162272A1 zeigt einen Substrathalter auf, der über mehrere Fixierzonen verfügt, die insbesondere symmetrisch über den Substrathalter verteilt sind und einzeln geschalten werden können. Die Druckschrift WO2018028801A1 zeigt ein Verfahren auf, um ein Substrat nicht radialsymmetrisch, sondern uniaxial zu fixieren und auch in seiner uniaxialen Krümmung loszulassen. In der Druckschrift WO2014191033A1 wird ein Substrathalter offenbart, dessen Oberfläche gekrümmt bzw. krümmbar ist, um ein darauf fixiertes Substrat mit einer inhomogenen Krümmung zu versehen, bevor und/oder während es gebondet wird. Die Druckschrift WO2014191033A1 erwähnt insbesondere auf Seite 9, dass die einstellbare Krümmung keine homogene, d.h. eine inhomogene, Krümmung ist. Mit jeder neuen Generation von Substrathaltern wurden bessere und schnellere Bondergebnisse erzielt, die aber durch weitere technologische Verbesserung immer noch optimiert werden können. Mittlerweile hat man erkannt, dass den beiden Substrathaltern in einem Bondvorgang eine entscheidende Bedeutung zukommt. Insbesondere die Steuerung einer fortlaufenden Bondwelle in einem Fusionsbond ist extrem wichtig für ein korrektes Bondergebnis. Die Steuerung wird insbesondere auch durch die Art und Weise beeinflusst, wie die Substrate, die am Bondvorgang teilnehmen, gekrümmt werden.

Eines der Probleme im Stand der Technik besteht darin, dass nicht nur die Oberfläche, auf der das Substrat fixiert wird, wohldefiniert gekrümmt wird, sondern, dass auch andere Bauteile des Substrathalters während des Krümmungsvorgangs mechanisch beeinflusst, insbesondere gekrümmt, werden. Konstruktionstechnisch möglich wäre ein Substrathalter in Massivbauweise, d.h. eine Konstruktion, die aus sehr dicken und massigen Teilen besteht, die einen großen Biegewiderstand besitzen. Allerdings müssen manche Substrathalter klein und kompakt, d.h. relativ filigran gebaut werden und besitzen daher notwendigerweise einen relativ geringen Biegewiderstand. Dieser niedrige Biegewiderstand bewirkt dann eine leichte, ungewollte, elastische Verformbarkeit einiger Teile des Substrathalters, die eigentlich nicht gekrümmt werden sollten. Diese elastischen Verformungen und Krümmungen wirken auf die Oberfläche, auf der das Substrat fixiert wird, die Fixierplattenoberfläche, zurück und beeinflussen so die Krümmung des Substrats. Dabei muss erwähnt werden, dass die entstehenden elastischen Verformungen sich natürlich nur um Nanometer oder Mikrometerbereich abspielen, allerdings sind bereits elastische Verformungen dieser Größenordnung ausreichend, um eine negative Rückwirkung auf das fixierte Substrat und dessen Krümmung zu erhalten.

Es ist möglich, auf einem Substrathalter durch Fräs-, Schleif-, Polier-, Ätz- und Läppprozesse eine homogene, gekrümmte Fixieroberfläche zu erzeugen, sodass das darauf fixierte Substrat ebenfalls eine homogene Krümmung besitzt. Diese Fixieroberfläche ist aber statisch und könnte die Krümmung nicht ändern. Andererseits wäre es möglich, einen Substrathalter zu bauen, der zwar die Fixieroberfläche krümmen kann, wie in der Druckschrift WO2014191033A1. Bei diesen Substrathaltern zeigt es sich allerdings, dass es sehr schwierig ist die Krümmung der Fixieroberfläche und daher die Krümmung des Substrats, als Funktion des Ortes gezielt einzustellen, insbesondere konstant zu halten. Vor allem ist die Einstellung einer homogenen Krümmung des Substrats sehr schwer, gar nicht oder zumindest nicht reproduzierbar durchführbar.

Die zu lösende Aufgabe dieser Erfindung besteht darin, die Nachteile des Stands der Technik zu beseitigen und insbesondere darin, einen verbesserten Substrathalter, eine verbesserte Vorrichtung und ein verbessertes Verfahren zum Bonden anzugeben.

Diese Aufgabe wird mit den Merkmalen der nebengeordneten Ansprüche gelöst. Vorteilhafte Weiterbildungen der Erfindung sind in den Unteransprüchen angegeben. In den Rahmen der Erfindung fallen auch sämtliche Kombinationen aus zumindest zwei von in der Beschreibung, den Ansprüchen und/oder den Figuren angegebenen Merkmalen. Bei angegebenen Wertebereichen sollen auch innerhalb der genannten Grenzen liegende Werte als Grenzwerte offenbart gelten und in beliebiger Kombination beanspruchbar sein.

Von technischer Bedeutung ist es insbesondere, einen Substrathalter so zu konstruieren, dass er ein Substrat gezielt einstellbar, insbesondere homogen, krümmt.

Die Erfindung betrifft einen Substrathalter zum Krümmen eines Substrats, aufweisend
- eine Fixierplatte zur Befestigung des Substrats,
- Krümmungsmittel zur Krümmung der Fixierplatte,
wobei die Fixierplatte derart ausgebildet ist, dass die Krümmung des Substrats bzw. der Fixierplatte gezielt einstellbar ist.

Die Fixierplatte hat eine Vorderseite, auf der das Substrat befestigt ist, und eine der Vorderseite abgewandte Rückseite. Die Fixierplatte weist eine Breite, eine Länge und eine Dicke auf. In einer anderen Ausführungsform ist die Fixierplatte radialsymmetrisch ausgelegt und wird dann über einen Radius und eine Dicke definiert. Die Breite und die Länge erstrecken sich in Richtung einer Fixierplattenoberfläche auf der Vorderseite der Fixierplatte, auf der das Substrat fixiert wird. Die Dicke erstreckt sich senkrecht zur Fixierplattenoberfläche.

Bevorzugt variiert die Dicke der Fixierplatte, d.h. die Dicke ist nicht an jeder Stelle gleich, sondern die Fixierplatte ist an mindestens einer Stelle der Fixierplatte dicker als an einer anderen Stelle. Spezielle Ausbildungen/bevorzugte Formen werden im Weiteren beschrieben.

Bevorzugt ist vorgesehen, dass eine homogene Krümmung der Fixierplatte bzw. des Substrats einstellbar ist.

Bevorzugt ist vorgesehen, dass die Fixierplatte gelenkig gelagert ist.

Gezielt einstellbar bedeutet, dass der Wert der Krümmung festgelegt werden kann. Homogen bedeutet, dass bei festgelegtem Wert der Krümmung diese Krümmung an jeder Position der Fixierplatte bzw. des Substrats, innerhalb einer verschwindend geringen Fehlertoleranz, gleich, d.h. konstant ist.

Bevorzugt ist die Rückseite der Fixierplatte so geformt, dass sich eine homogene Krümmung der Fixierplatte ergibt bzw. dass eine homogene, daher an jedem Ort gleiche, Krümmung der Fixierplatte bzw. Fixierplattenvorderseite und damit des Substrats einstellbar ist.

In einer bevorzugten Ausführungsform, aber auch als eigenständiger erfinderischer Aspekt, ist der Substrathalter so konstruiert, dass bei der Krümmung der Fixierplatte erzeugte Reaktionskräfte und/oder Momente durch mindestens ein Kompensationsmittel kompensierbar sind.

Als eigenständiger erfinderischer Aspekt betrifft die Erfindung einen Substrathalter zum Krümmen eines Substrats, aufweisend
- eine Fixierplatte zur Befestigung des Substrats,
- Krümmungsmittel zur Krümmung der Fixierplatte,
wobei bei der Krümmung der Fixierplatte erzeugte Reaktionskräfte durch mindestens ein Kompensationsmittel kompensierbar sind.

Die Erfindung betrifft weiterhin eine Vorrichtung, insbesondere Bondvorrichtung, aufweisend mindestens einen erfindungsgemäßen Sub strathalter.

Die Erfindung betrifft weiterhin ein Verfahren zum Bonden zweier Substrate, aufweisend die folgenden Schritte, wobei:
- ein erstes Substrat auf einem ersten, insbesondere erfindungsgemäßen, Substrathalter befestigt wird,
- ein zweites Substrat auf einem zweiten, insbesondere erfindungsgemäßen, Substrathalter befestigt wird,
- die Substrate (7) zueinander ausgerichtet werden,
- mindestens eines der Substrate (7) gekrümmt wird,
- die Substrate kontaktiert werden,
wobei die Krümmung mindestens eines der Substrate bzw. der Fixierplatte gezielt eingestellt wird, bevorzugt homogen ist.

Bevorzugt und als eigenständiger erfinderischer Aspekt werden bei der Krümmung der Fixierplatte die in den restlichen Bauteilen erzeugten Momente und/oder Reaktionskräfte entweder kompensiert, vorzugsweise aber erst gar nicht oder nur in geringem Umfang auf die Fixierplatte übertragen.

Ein weiterer eigenständiger Aspekt der Erfindung betrifft daher ein Verfahren zum Bonden zweier Substrate, aufweisend die folgenden Schritte, wobei:
- ein erstes Substrat auf einem ersten, insbesondere erfindungsgemäßen, Substrathalter befestigt wird,
- ein zweites Substrat auf einem zweiten, insbesondere erfindungsgemäßen, Substrathalter befestigt wird,
- die Substrate zueinander ausgerichtet werden,
- mindestens eines der Substrate gekrümmt wird,
- die Substrate kontaktiert werden,
wobei bei der Krümmung der Fixierplatte die in den restlichen Bauteilen erzeugten Momente und/oder Reaktionskräfte entweder kompensiert, vorzugsweise aber erst gar nicht oder nur in geringem Umfang auf die Fixierplatte übertragen werden. Bevorzugt wird das durch die Verwendung eines Lagers bewerkstelligt, über das möglichst keine bzw. nur sehr geringe Reaktionskräfte und/oder Momente übertragen werden.

Bevorzugt ist vorgesehen, dass die Fixierplatte im Zentrum dicker ist als am Rand. Dadurch kann vorteilhaft eine besonders homogene Krümmung der Fixierplatte und des Substrats erreicht werden. Bevorzugt ist die Fixierplatte zum Rand hin verjüngt ausgebildet. Bevorzugt ist vorgesehen, dass die Fixierplatte symmetrisch zum Zentrum ausgebildet ist.

Der wesentliche erfindungsgemäße Aspekt besteht insbesondere darin, dass einem Substrat eine Krümmung aufgeprägt werden kann, die man gezielt einstellen kann. Insbesondere wird es möglich, Krümmungen mit konstantem, d.h. homogenem, Krümmungsradius zu erzeugen. Das Einstellen einer konstanten Krümmung stellt die bevorzugteste, erfindungsgemäße Vorgehensweise zur Erzeugung eines Bonds dar. Durch eine erfindungsgemäße Erweiterung und der Ausführungsformen werden die Reaktionskräfte, die gemäß des dritten Newtonschen Axioms notwendigerweise immer entstehen, nicht von den Bauteilen des Substrathalters aufgenommen, die über mechanische Kopplung mit der Platte verbunden sind, die das Substrat fixiert, sondern von einer zweiten Platte, der Kompensationsplatte, die sich im Inneren des Substrathalters befindet und zusammen mit der ersten Platte frei (gelenkig) gelagert ist, d.h. im Idealfall kein oder nur ein verschwindend geringes Moment übertragen kann.

Unter einer Krümmung versteht man die Abweichung von der Form eines Objekts von einem unbelasteten Ausgangszustand, insbesondere dadurch gekennzeichnet, dass sich die Position der Mittellinie oder Mittelfläche des Objektes unter Last ändert.

Die Krümmung wird am einfachsten als Kehrwert des Krümmungsradius für einen Punkt der Kurve beschrieben. Der Krümmungsradius an einem Punkt ist der Radius des Schmiegekreises an die Kurve durch diesen Punkt. Je größer der Krümmungsradius, desto kleiner ist die Krümmung.

In der Halbleiterindustrie existiert noch der Ausdruck "Bogen" (engl.: bow). Darunter versteht man die Abweichung des Zentrumspunkts der Medianfläche des Substrats eines freien, nicht geklemmten Substrats, insbesondere Wafers, von der Medianfläche der Referenzebene. Die Referenzebene ist einfach eine horizontale, plane Ebene, auf welcher das Substrat eingeklemmt aufliegt. Die genaue Definition findet sich in der mittlerweile veralteten ASTM F534 Norm.

Im weiteren Verlauf des Textes werden Biegelinie und Biegefläche als Synonyme verwendet, insbesondere da die erfindungsgemäßen Substrathalter in den Figuren vorzugsweise im Querschnitt gezeichnet werden und daher anstatt einer Biegefläche nur eine Biegelinie erkennbar ist. Der Fachmann auf dem Gebiet versteht, dass eine zweidimensionale Oberfläche eines dreidimensionalen Körpers im Allgemeinen eine Biegefläche besitzt und dass im Querschnitt durch eine solche Biegefläche nur eine Biegelinie erkennbar bzw. darstellbar ist.

In den besonders bevorzugten erfindungsgemäßen Ausführungsformen der Substrathalter und Verfahren wird ein Substrat mit einer konstanten Krümmung gekrümmt, d.h. die Krümmung ist an jeder Position des Substrats gleich. Die Krümmung wird dann auch als homogen bezeichnet. Eine konstante Krümmung eines Substrats erzeugt besonders optimale Bonds zwischen zwei Substraten. Eine solche Krümmung lässt sich insbesondere dann erreichen, wenn man dafür sorgt, dass keine Reaktionskräfte und/oder Momente andere Bauteile auf die Fixierplatte zurückwirken. Bevorzugt wird das durch die Verwendung eines Lagers bewerkstelligt, welches keine bzw. nur eine sehr geringe Übertragung von Reaktionskräften und/oder Momenten zulässt.

Im Allgemeinen kann die Krümmung über das Substrat auch variieren. Vorzugsweise ist die Krümmung allerdings radialsymmetrisch, d.h. sie ändert sich nur mit der radialen Position gemessen vom Zentrum des Substrats, nicht aber mit dem Winkel. Substrate, die anisotrope Krümmungen ausbilden, d.h. deren Krümmung im Allgemeinen mit der Radiusposition und dem Winkel variiert, haben die Eigenschaft Satteloberflächen auszubilden. Da die Steifigkeit der erfindungsgemäßen Fixierplatte, insbesondere des gesamten erfindungsgemäßen Substrathalters, allerdings viel größer ist als die Steifigkeit des Substrats und das Substrat durch Fixierelement an der Fixierplatte fixiert wird, kann davon ausgegangen werden, dass das Substrat die Fixierplatte an jedem Punkt kontaktiert. In diesem Fall würde die Zwangsbedingung, welche die Entstehung einer Krümmung in Form einer Satteloberfläche nicht zulässt, zu Eigenspannungen im Substrat führen.

Der Krümmungsradius einer Platte bzw. eines Substrats ist größer als 0.01m, vorzugsweise größer als 0.1m, noch bevorzugter größer als 1m, am bevorzugtesten größer als 10m, am allerbevorzugtesten größer als 100m.

Ist der Krümmungsradius entlang der Biegelinie bzw. Biegefläche nicht konstant, so ist der Absolutbetrag der Differenz zwischen größtem und kleinstem Krümmungsradius kleiner als 1m, vorzugsweise kleiner als 0.1m, noch bevorzugter kleiner als 0.01m, am bevorzugtesten kleiner als 0.001m, am allerbevorzugtesten kleiner als 0.0001m.

Der Bogen ist kleiner als 1000µm, vorzugsweise kleiner als 500µm, noch bevorzugter kleiner als 100µm, am bevorzugtesten kleiner als 10µm, am allerbevorzugtesten kleiner als 1µm.

Vorzugsweise können die erfindungsgemäßen Ausführungsformen und Verfahren ein Substrat so krümmen, dass die Oberfläche im Querschnittprofil bzw. die Biegelinie durch eine der folgenden mathematischen Funktionen beschrieben werden kann:
- Ellipsenabschnitt, vorzugsweise
   o Kreisabschnitt
- Parabel
- Hyperbel
- Sinus, insbesondere im Wertebereich [0, Pi]
- Negativer Cosinushyperbolicus

Die Biegefläche ist dann insbesondere durch eine der folgenden Funktionen beschreibbar.
- Ellipsoidenabschnitt, insbesondere
   o Kreisschalenabschnitt
- Paraboloid
- Hyperboloid

Im Allgemeinen sind die Biegeflächen daher die durch Rotation der Biegelinien entstehenden Oberflächen.

Von all den oben genannten möglichen Biegelinien- bzw. Biegeflächenformen sind jene am bevorzugtesten, welche eine homogene Krümmung aufweisen, d.h. die Kreisabschnitte bzw. Kreisschalenabschnitte.

Diese bevorzugte Einstellbarkeit einer homogenen Krümmung wird durch eine genau definierte und präzise hergestellte Hohlraumplattenoberfläche der Fixierplatte erzeugt. Durch die Herstellung einer definierten und präzise hergestellten Hohlraumplattenoberfläche der Fixierplatte wird die Endform der Fixieroberfläche der Fixierplatte und damit des Substrats genau definiert. Insbesondere verwendet man Berechnungsverfahren, vorzugsweise Finite Elemente Methoden, um die Form der Hohlraumplattenoberfläche der Fixierplatte zu bestimmen. Die Form der Hohlraumplattenoberfläche der Fixierplatte kann insbesondere durch eine der oben genannten mathematischen Funktionen beschrieben werden.

Die tatsächliche Form der zu fertigenden Hohlraumplattenoberfläche der Fixierplatte hängt allerdings von vielen Faktoren ab...
- Biegewiderstand der Fixierplatte
- Biegewiderstand des gesamten Substrathalters
- Verwendetes Krümmungsmittel, insbesondere
   - Verwendeter Fluiddruck bei Verwendung eines Fluids
- etc.

Ein erfindungsgemäßer Gedanke besteht insbesondere darin, nur eine, einzige starre Hohlraumplattenoberfläche der Fixierplatte präzise zu fertigen und mit dieser dann durch die steuerbare Stellmittel jede Krümmung an der Fixieroberfläche der Fixerplatte und damit am Substrat einstellen zu können, insbesondere so, dass die Krümmung am Substrat homogen, d.h. an jedem Ort gleich, ist.

Erfindungsgemäß wird diese Methode der gezielt einstellbaren Krümmung eines Substrats über die Schaffung einer präzise gefertigten Hohlraumplattenoberfläche der Fixierplatte weiter unterstützt und verbessert, indem man mindestens ein Kompensationsmittel einsetzt, um eine mechanische Rückwirkung bei der Krümmung der Fixierplatte zu vermindern bzw. gänzlich zu verhindern.

Bevorzugt ist vorgesehen, dass das mindestens eine Kompensationsmittel eine, insbesondere krümmbare, Kompensationsplatte umfasst.

Bevorzugt ist vorgesehen, dass die Kompensationsplatte entgegen der Krümmung der Fixierplatte krümmbar ist.

Bevorzugt ist vorgesehen, dass zwischen der Fixierplatte und der Kompensationsplatte ein, bevorzugt abgedichteter, Zwischenraum erzeugbar ist.

Bevorzugt ist vorgesehen, dass die Krümmung der Fixierplatte und der Kompensationsplatte durch ein Fluid erzeugbar ist, das in den Zwischenraum pressbar ist.

Bevorzugt ist vorgesehen, dass der Zwischenraum durch ein Fluidmittel, ein mechanisches Stellmittel und/oder elektrostatische Kräfte erzeugbar ist.

Bevorzugt ist vorgesehen, dass die Fixierplatte und die Kompensationsplatte über eine, bevorzugt gelenkige, Lagerung miteinander verbunden sind.

Bevorzugt ist vorgesehen, dass die Fixierplatte und die Kompensationsplatte über eine, bevorzugt gelenkige, Lagerung mit den übrigen Bauteilen des Substrathalters verbunden sind.

Bevorzugt ist vorgesehen, dass über eine Peripherie der Fixierplatte und/oder der Kompensationsplatte, nur ein geringes Moment, bevorzugt kein Moment, übertragbar ist. Das übertragene Moment ist kleiner als 1Nm, vorzugsweise kleiner als 10⁻³ Nm, noch bevorzugter kleiner als 10⁻⁵ Nm, am bevorzugtesten kleiner als 10^{-7'}Nm, am allerbevorzugtesten 0 Nm.

Bevorzugt ist vorgesehen, dass die Kompensationsplatte in ihrem äußeren Bereich eine, vorzugsweise vollumfängliche und geschlossene, Nut aufweist. Der Abstand zwischen der Nut und der äußeren Peripherie der Kompensationsplatte ist kleiner als 50mm, vorzugsweise kleiner als 40mm, noch bevorzugter kleiner als 30mm, am bevorzugtesten kleiner als 20mm, am allerbevorzugtesten kleiner als 10mm.

Bevorzugt ist vorgesehen, dass die Kompensationsplatte in ihrem äußeren Bereich ein Dichtmittel, bevorzugt einen Dichtring, aufweist, wobei das Dichtmittel bevorzugt auf einem, insbesondere vollumfänglichen und geschlossenen, Podest angeordnet ist. Der Dichtring erlaubt die Erzeugung eines Drucks von mehr als 1bar, vorzugsweise mehr als 1.2 bar, noch bevorzugter mehr als 1.5 bar, am bevorzugtesten mehr als 2bar, am allerbevorzugtesten mehr als 2.5bar.

Bevorzugt ist vorgesehen, dass das mindestens eine Kompensationsmittel eine gelenkige Lagerung der Fixierplatte umfasst. Die gelenkige Lagerung, die nicht in der Lage ist, Reaktionskräfte und/oder Momente von den anderen Bauteilen des erfindungsgemäßen Substrathalters auf die Fixierplatte zu übertragen, wird also selbst als Kompensationsmittel im Sinne dieser Offenbarung angesehen.

Einer weiteren bevorzugten Ausführungsform der Erfindung liegt insbesondere der Gedanke zu Grunde, einen Substrathalter zu konstruieren, der über zwei Platten verfügt, die in zwei jeweils entgegengesetzte Richtungen gekrümmt werden können. Die Krümmung erfolgt dabei durch Stellmittel (im Folgenden auch Krümmungsmittel genannt), insbesondere durch Verwendung eines Fluids, dass in den Zwischenraum der beiden Platten gepresst wird. Durch die Verwendung von zwei Platten wirkt die, durch die Verformung der ersten Platte erzeugte, Reaktionskraft nicht auf die Unterseite des Substrathalters, der die erste Platte hält, sondern auf die erfindungsgemäß zweite eingebaute Platte. Dadurch wird eine schädliche und beeinflussende Rückwirkung der Reaktionskraft auf den Substrathalter und damit das Substrat eliminiert. Die Reaktionskraft wird vielmehr von der zweiten Platte aufgenommen (kompensiert), die sich frei in Richtung des Substrathalters verformen kann. Des Weiteren beschreibt die Erfindung eine Vorrichtung, insbesondere Bondvorrichtung, die den erfindungsgemäßen Substrathalter an mindestens einer Seite der Vorrichtung verwendet.

### Substrathalter

Im Folgenden werden die erfindungsgemäßen Substrathalter im Detail beschrieben. Insbesondere kommt es darauf an, alle konstruktionstechnischen Maßnahmen zu verstehen, mit deren Hilfe man eine eistellbare, insbesondere homogene, Krümmung erzeugen kann. Des Weiteren werden konstruktionstechnische Maßnahmen offenbart, mit deren Hilfe man die auf die obere Platte rückwirkenden Kräfte und Momente, sowie deren Vermeidung verstehen kann.

Alle erfindungsgemäßen Substrathalter verfügen über eine Fixieroberfläche. Die Fixieroberfläche ist insbesondere Teil einer Fixierplatte. Die Fixierplatte besitzt eine, der Fixieroberfläche gegenüberliegende, Hohlraumoberfläche. Bevorzugt ist die Hohlraumoberfläche gemäß einer mathematischen Funktion geformt. Die Form der Hohlraumoberfläche bewirkt durch die Anwendung eines Stellelements eine wohldefinierbare, insbesondere homogene Krümmung.

Die Normalkomponente einer Kraft, die auf einen Hebel wirkt, erzeugt im Angriffspunkt des Hebels ein Moment. Um die Darstellung der Erfindung zu vereinfachen wird im weiteren Verlauf des Textes immer nur von Kräften die Rede sein, obwohl die entstehenden Kräfte auch Momente hervorrufen. Die Summe der Momente und die Summe der Kräfte müssen null sein. Alle sich daraus ergebenden Konsequenzen gelten damit auch als offenbart.

Die erfindungsgemäßen Substrathalter sind vorzugsweise immer so konstruiert, dass eine Kraft eine obere, erste Platte krümmt, und die dabei entstehenden Gegenkraft nicht über jene Bauteile, die die Platte lagern bzw. halten, aufgenommen wird, sondern über eigens dafür vorgesehene Kompensationsbauteile, insbesondere eine zweite, untere Platte. Die zweite, untere Platte darf dabei auch nicht oder nur sehr schwach mechanisch mit den restlichen Bauteilen des Substrathalters verbunden sein, da sie sonst erst wieder mit der oberen ersten Platte mechanisch gekoppelt wäre und ein Moment übertragen könnte. Ein charakteristisches Merkmal muss darin bestehen, dass über die Peripherie, insbesondere beider Platten, kein oder zumindest nur ein verschwindend geringes Moment übertragen werden kann. Die Platten, sowie einige andere notwendige Maschinenelemente müssen also an der Peripherie möglichst ein ideales Loslager, insbesondere ein möglichst ideales Gelenk, bilden.

In einer speziellen bevorzugten Ausführungsform besteht der erfindungsgemäße Substrathalter daher aus mindestens zwei Platten, die krümmbar, und vor allem gelenkig gelagert sind.

In einer ersten speziellen, bevorzugten erfindungsgemäßen Ausführungsform sind die Platten selbst das Stellelement das ihre Krümmung hervorruft, indem man die Platten auf Potential setzt, eine Oberflächenladung erzeugt und elektrostatische Kräfte für die Krümmung der Platten sorgen. Die Platten sind dabei elektrisch voneinander isoliert. Eine solche Isolierung kann darin bestehen, dass die Oberflächen in der Peripherie der Substrate aus einem dielektrischen Material bestehen bzw. mit einem dialektischen Material beschichtet wurden.

Andere Teilbereiche der Platten, insbesondere an den Oberflächen der Platten, die aufeinander zugerichtet sind, sind Elektrika, d.h. elektrisch leitfähig. Insbesondere sind die ganzen Platten, mit Ausnahme ihrer isolierenden Randbereiche, elektrisch leitfähig. Beide Platten können auf ein, insbesondere positives, Potential in Bezug zu Masse gesetzt werden. Denkbar ist auch, dass beide Platten auf ein negatives Potential in Bezug zu Masse gesetzt werden. Durch die gleichpolige Aufladung beider Platten, stoßen sich beide Platten voneinander ab. Würden die Platten an ihrer Peripherie nicht elektrisch isoliert sein, würden sich die Ladungen an die äußeren Oberflächen der beiden Platten bewegen. Auf den inneren, dem Hohlraum zugewandten, Oberflächen der beiden Platten würden sich keine Ladungen befinden und der Hohlraum wäre feldfrei.

Dementsprechend würden sich die Platten nicht erfindungsgemäß nach außen krümmen können. Die elektrische Isolierung der beiden auf potential gebrachten Platten ist daher ein wesentlicher erfindungsgemäßer Aspekt dieser sehr speziellen Ausführungsform. In einer speziellen Erweiterung der erfindungsgemäßen Ausführungsform können elektrisch voneinander isolierte Bereiche der beiden Platten elektrisch leitfähig sein und jeder dieser elektrisch leitfähigen Bereiche kann einzeln und unabhängig von den anderen elektrischen Bereichen auf ein wohldefiniertes elektrisches Potential gesetzt werden. Dadurch wird es möglich, die Abstoßung der Platten örtlich genau einzustellen. Je feiner die Segmentierung der elektrisch leitfähigen Bereiche, desto genauer die Ortsauflösung der einstellbaren Krümmung.

In einer zweiten speziellen, bevorzugten erfindungsgemäßen Ausführungsform werden die beiden Platten durch ein mechanisches Stellelement, das sich zwischen den Platten befindet, gekrümmt. Das mechanische Stellelement kann elektrisch und/oder pneumatisch und/oder hydraulisch betrieben werden. Besonders bevorzugt werden piezoelektrische Säulen als Stellmittel verwendet. Insbesondere ist auch wieder die Verwendung mehrerer solcher mechanischer Stellelemente, die sich auf mehrere, insbesondere symmetrische Positionen, zwischen den Platten befinden, möglich. In diesem Fall kann vorzugsweise wieder jedes der Stellmittel unabhängig von allen anderen Stellmitteln eingestellt werden.

In einer dritten, speziellen besonders bevorzugten erfindungsgemäßen Ausführungsform werden die Platten durch ein Fluid gekrümmt, das in einen Zwischenraum eingeleitet, insbesondere gepumpt, wird. Bei dem Fluid handelt es sich um eine Flüssigkeit, eine Flüssigkeitsmischung, ein Gas oder ein Gasgemisch. Am allerbevorzugtesten handelt es sich bei dem Fluid um Luft. Dadurch kommt es zu einer, insbesondere symmetrischen, Krümmung beider Platten.

Der erfindungsgemäße Gedanke hinter den speziellen erfindungsgemäßen Ausführungsformen besteht insbesondere darin, dass die untere Platte sich frei dehnen kann und keine Kraft und/oder kein Moment auf die restlichen Bauteile des Substrathalters überträgt, sodass dieser nicht verformt wird. Insbesondere soll die Krümmung der ersten Platte, der Fixierplatte, und damit die Krümmung des darauf fixierten Substrats, nicht durch ein mechanisch rückwirkendes Moment bzw. eine mechanisch rückwirkende Kraft verändert werden.

### Platten

Der erfindungsgemäße Substrathalter weist insbesondere mindestens eine, an Ihrer Rückseite speziell geformte Platte auf. In einer speziellen erfindungsgemäßen Ausführungsform weist der Substrathalter zwei Platten auf.

Es gibt zwei grundsätzliche Arten von Platten, die Fixierplatte und die Kompensationsplatte. Die Fixierplatte ist die Platte, auf der das zu krümmende Substrat fixiert wird. Die Kompensationsplatte ist die Platte, die den erfindungsgemäßen Effekt der Aufnahme der Kräfte und/oder Momente der Stellmittel übernimmt und so eine mechanische Rückkopplung auf die anderen Bauteile des Substrathalters weitestgehend verhindert. Insbesondere ist auch die Lagerung der Platten maßgeblich dafür verantwortlich, dass keine Kräfte und/oder Momente von anderen Bauteilen auf die Fixierplatte übertragen werden.

Der Raum zwischen den beiden Platten wird als Hohlraum bezeichnet. Alle Platten verfügen über eine Hohlraumplattenoberfläche und eine der Hohlraumplattenoberfläche gegenüberliegende zweite Plattenoberfläche, die abhängig von der Funktion der Platte unterschiedlich verwendet wird.

Die Hohlraumplattenoberfläche ist immer die Oberfläche, die dem Hohlraum zwischen den beiden Platten zugewandt ist. In einer besonders bevorzugten erfindungsgemäßen Ausführungsform sind die Hohlraumplattenoberflächen speziell geformt. Insbesondere die Hohlraumplattenoberfläche der Platte, die das Substrat fixiert, besitzt eine wohldefinierte Form, die sich positiv auf das Krümmungsverhalten der Platte und damit auf das Krümmungsverhalten des Substrats auswirkt.

Wird eine Unterscheidung zwischen der Hohlraumplattenoberfläche der Fixierplatte und der Kompensationsplatte notwendig, dann werden diese entsprechend als Hohlraumfixierplattenoberfläche und Hohlraumkompensationsplattenoberfläche bezeichnet. Die Hohlraumplattenoberflächen können beliebig geformt sein, können aber vorzugsweise gemäß einer Funktion beschrieben werden, die bereits für die Beschreibung der Biegelinie bzw. Biegefläche verwendet wurde. Alle für die Biegelinie und/oder Biegefläche offenbarten Funktionen gelten daher auch als für die Beschreibung der Hohlraumplattenoberflächen als offenbart.

Die Plattenoberfläche, welche ein Substrat fixiert, wird als Fixierplattenoberfläche bezeichnet. Eine Fixierplattenoberfläche kann sich demnach immer nur auf einer Fixierplatte befinden.

Die Fixierplattenoberfläche verfügt über Fixierungen, um das Substrat zu fixieren. Bei den Fixierungen kann es sich insbesondere um
1. Mechanische Fixierungen, insbesondere
   1.1. Klemmen
2. Vakuumfixierungen, insbesondere mit
   2.1. einzeln ansteuerbare Vakuumbahnen
   2.2. miteinander verbundenen Vakuumbahnen
3. Elektrische Fixierungen, insbesondere
   3.1. Elektrostatische Fixierungen
4. Magnetische Fixierungen
5. Adhäsive Fixierungen, insbesondere
6. Gel-Pak Fixierungen und/oder
7. Fixierungen mit adhäsiven, insbesondere ansteuerbaren, Oberfläche handeln.

Die Fixierungen sind insbesondere pneumatisch und/oder hydraulisch und/oder elektronisch ansteuerbar.

Die Vakuumfixierung ist die bevorzugte Fixierungsart. Die Vakuumfixierung besteht vorzugsweise aus mehreren Vakuumbahnen, die an der Oberfläche des Substrathalters austreten. Die Vakuumbahnen sind vorzugsweise einzeln ansteuerbar. In einer technisch eher realisierbaren Anwendung sind einige Vakuumbahnen zu Vakuumzonen vereint, die einzeln ansteuerbar, daher evakuiert oder geflutet werden können. Jede Vakuumzone ist allerdings unabhängig von den anderen Vakuumzonen. Damit erhält man die Möglichkeit des Aufbaus einzeln ansteuerbarer Vakuumzonen. Die Vakuumzonen sind vorzugsweise ringförmig konstruiert. Dadurch wird eine gezielte, radialsymmetrische, insbesondere von Innen nach Außen durchgeführte Fixierung und/oder Loslösung eines Substrats vom Substrathalter ermöglicht.

In einer weiteren Verbesserung sind die ringförmig segmentierten Vakuumzonen entlang eines Ringumfangs nochmals segmentiert, sodass sich jede Vakuumzone entlang des Ringumfangs in mehrere Vakuumzonen aufteilt. Derartige Ausführungsformen wurden ausführlich in der Druckschrift WO2017162272A1 offenbart.

In einer ganz besonders bevorzugten erfindungsgemäßen Ausführungsform befinden sich auf der Fixierplattenoberfläche sogenannte Stifte (engl.: pins). Die Druckschrift WO2015113641A1 erwähnte eine derartige Struktur. Durch diese Stifte liegt ein Substrat nicht vollflächig auf, sondern kontaktiert die Fixieroberfläche größtenteils nur an den Stiften. Dadurch werden einerseits Kontaminationen vermindert, andererseits kann in den Zwischenräumen der Stifte ein Vakuum entlang der gesamten Fixierfläche der Fixierplatte aufgebaut werden. Insbesondere sind die Stifte in den Vakuumzonen gruppiert, die bereits erwähnt wurden. Diese Ausführungsformen wurden ebenfalls ausführlich in der Druckschrift WO2017162272A1 offenbart. Insbesondere die Gruppierung der Stifte und Vakuumdurchführungen zu Vakuumzonen, die auf der Fixierplatte verteilt sind und vor allem einzeln angesteuert werden können, wird hiermit explizit offenbart und stellt im Zusammenhang mit der eigentlichen erfindungsgemäßen Idee eine entscheidende Verbesserung des erfindungsgemäßen Substrathalters dar.

Obwohl die erwähnte Verwendung von Vakuumzonen gemäß der Druckschrift WO2017162272A1, die insbesondere jeweils durch mindestens ein Vakuumloch evakuiert bzw. geflutet werden können, als eine spezielle, nutzbringende und wichtige Erweiterung der erfindungsgemäßen Idee gilt, werden die erfindungsgemäßen Substrathalter im weiteren Verlauf des Textes mit einer Fixermethode beschrieben, bei der sich nur eine sehr geringe Anzahl von Vakuumlöchern, insbesondere im Zentrum, auf der Fixierplattenoberfläche befinden.

In den erfindungsgemäßen Ausführungsformen, in denen eine Fixierung des Substrats mittels einer Vakuumfixierung erfolgt, wird das Vakuum zwischen dem Substrat und der Fixierplattenoberfläche vorzugsweise über Vakuumlöcher erzeugt, die entlang eines Kreises gebohrt wurden, dessen Kreismittelpunkt das Zentrum der Fixierplatte ist. Dadurch wird es bei der Verwendung eines Substrathalters mit Stiften (engl.: pins chuck) möglich, einen der Pins genau im Zentrum der Fixierplatte zu positionieren, was sich nachweislich positiv auf das Bondergebnis auswirkt. Eine genaue Beschreibung und Darstellung erfolgt in der Figurenbeschreibung und den Figuren. Es ist daher ein weiteres erfindungsgemäßes Merkmal, einen Substrathalter mit Stiften zu offenbaren, der einen der Stifte genau unterhalb der Position, an der es zum Erstkontakt beider Substrate kommt, besitzt. Durch einen solchen Stift unterhalb des Kontaktpunktes beider Substrate kommt es zu einer mechanischen Stabilisierung der Substrate in diesem Punkt. Da von diesem Punkt aus die Bondwelle zu laufen beginnt, ist die Koinzidenz eines solchen Stiftes mit dem Kontaktpunkt entlang einer Line normal auf die Fixierplattenoberfläche entscheidend für einen stabilen Start der Bondwelle. Anschaulich kann man den Effekt eines Pins genau unter der Kontaktstelle so darstellen, dass der Pin unterhalb der Kontaktstelle ein durchdrücken der Substrate in diesem Punkt unterbindet und damit eine stabile mechanische Ausgangssituation erzeugt.

Bei der zweiten Platte handelt es sich um eine Kompensationsplatte. Die Kompensationsplatte besitzt vorzugsweise eine vollumfängliche und geschlossene Nut in einem äußeren Bereich. Die Nut dient dazu, dass die Krümmung der unteren Platte sich nicht vollständig bis zu Ihrem Rand, sondern hauptsächlich bis zu dieser Nut fortsetzt. Die Nut fängt die Krümmung also ab, bevor sie die Peripherie erreicht. Dadurch wird eine immer noch mögliche, kleine Rückwirkung auf den Substrathalter weiter vermindert weiter vermindert. Sollte die Lagerung der Kompensationsplatte an der Peripherie so gut sein, dass kein Moment übertragen wird, könnte auf eine entsprechende Nut verzichtet werden. Dennoch ist die Ausführung einer solchen Nut eigentlich immer nutzbringend. Die Kompensationsplatte trägt vorzugsweise auch Dichtmittel, insbesondere einen Dichtring. Das Dichtmittel befindet sich mit Vorzug auf einem kleinen, vollumfänglichen und geschlossenen Podest.

### Anlage

Alle erfindungsgemäßen Substrathalter können in einer erfindungsgemäßen Anlage für die Fixierung eines unteren und/oder oberen Substrats verwendet werden. Besonders bevorzugt werden die erfindungsgemäßen Substrathalter in einer Bondanlage für die Fixierung des unteren und des oberen Substrats verwendet. Dadurch wird die Steuerung des Bond-, insbesondere Fusionsbonds, besonders verbessert und optimiert. Durch die Verwendung des erfindungsgemäßen Substrathalters als ein Oberseitensubstrathalter wird insbesondere der, in der Halbleiterindustrie lange eingesetzt Krümmungsstift (engl.: pin), der die zentrische Krümmung eines Substrats initiiert hat, ersetzt.

Die bevorzugte erfindungsgemäße Ausführungsform einer Anlage besteht als darin, einen erfindungsgemäßen Substrathalter für die Fixierung des oberen und einen erfindungsgemäßen Substrathalter für die Fixierung des unteren Substrats zu verwenden.

Eine spezielle erfindungsgemäße Anlage besteht aus einem erfindungsgemäßen Substrathalter an der Unterseite und einem beliebigen anderen, nicht erfindungsgemäßen Substrathalter. Der obere Substrathalter verfügt dabei vorzugsweise über die, im Stand der Technik bekannten, Krümmungsmittel, insbesondere einen Krümmungsstift oder eine Düse, aus der ein Fluid austritt, welches das obere Substrat entsprechend krümmt.

In einer besonderen Erweiterung einer erfindungsgemäßen Anlage befindet sich in dem Bonder auch eine Ausrichtungsvorrichtung (engl.: aligner).

Sind die Substrate transparent für elektromagnetische Strahlung einer gewissen Frequenz, sind vorzugsweise Beobachtungsvorrichtungen vorhanden um den Verlauf der bondwelle zu analysieren. Dadurch kann nicht nur der Bondvorgang beobachtet, beeinflusst und notfalls abgebrochen werden, sondern auch das Verhalten der Bondwelle als Funktion unterschiedlicher Parameter analysiert werden. Eine derartige Analyse hilft bei der weiteren Verbesserung der erfindungsgemäßen Substrathalter.

In einer besonderen Erweiterung einer erfindungsgemäßen Anlage können folgende Module an die erfindungsgemäße Anlage, insbesondere vakuumdicht, angeschlossen werden
- Reinigungsmodule
- Schleifmodule
- Ätzmodule, insbesondere
   o Zum chemischen Ätzen
   o Zum physikalischen Ätzen
- Plasmamodule
- Beschichtungsmodule

Derartige Module sind vorzugsweise Teil einer sogenannten Clusteranlage, in der es zwischen den Modulen vakuumdichte Tore gibt. Vorzugsweise befinden sich zwischen einigen der genannten Module auch Schleusen. Die Module können beliebig zueinander angeordnet werden. Vorzugsweise gibt es ein zentrales Modul, in dem sich ein Roboter befindet, der die Substrate zwischen den einzelnen Modulen transportieren kann. Ein derartiger, zentral ausgelegter Cluster, wird als Sterncluster bezeichnet. Denkbar ist auch, dass die Module in Reihe angeordnet sind.

### Verfahren

Das erfindungsgemäße Verfahren weist insbesondere die folgenden Schritte auf. Die Schritte müssen nicht notwendigerweise in der genannten Reihenfolge ablaufen.

In einem **ersten** erfindungsgemäßen Prozessschritt erfolgen ein Laden und ein Fixieren eines ersten Substrats auf einen ersten Substrathalter. Bei dem ersten Substrathalter handelt es sich vorzugsweise um einen erfindungsgemäßen Sub strathalter.

In einem **zweiten** erfindungsgemäßen Prozessschritt erfolgen ein Laden und ein Fixieren eines zweiten Substrats auf einen ersten Substrathalter. Bei dem ersten Substrathalter handelt es sich vorzugsweise um einen erfindungsgemäßen Substrathalter.

In einem **dritten** erfindungsgemäßen Prozessschritt erfolgt eine Ausrichtung der beiden Substrate zueinander. Die Ausrichtung erfolgt vorzugsweise an Hand von Ausrichtungsmarken, die sich auf den Substratoberflächen der Substrate befinden. Entsprechende Ausrichtungsanlagen, die auch gleichzeitig Teil einer erfindungsgemäßen Anlage, insbesondere Bondkammer, sein können, werden in den Druckschriften US6214692B1, WO2015082020A1, WO2014202106A1, WO2018041326A1 offenbart.

In einem **vierten** erfindungsgemäßen Prozessschritt erfolgt eine grobe Annäherung der Substrate aneinander.

In einem **fünften** erfindungsgemäßen Prozessschritt erfolgt die Einstellung einer gezielten erfindungsgemäßen, insbesondere homogenen, Krümmung mindestens eines der Substrate mit Hilfe eines erfindungsgemäßen Substrathalters. Denkbar ist auch, dass beide Substrate, insbesondere beide mit Hilfe eines erfindungsgemäßen Substrathalters, gekrümmt werden. Die, insbesondere homogene, Krümmung wird dabei durch die speziell geformte Rückseite der Fixierplatte ermöglicht. Bei der gezielt einstellbaren Krümmung kommt es irgendwann zum Kontakt der beiden Substrate und damit zur Initiierung einer Bondwelle.

Der Vollständigkeit halber wird noch folgende Anmerkung gemacht. Sollte es sich bei einem der Substrathalter nicht um einen erfindungsgemäßen Substrathalter handeln, kann dieser über ein gewöhnliches, im Stand der Technik bekanntes, Verformungselement für eine Verformung des Substrats verfügen. Dieser nicht erfindungsgemäße Substrathalter weist dann natürlich alle negativen Konsequenzen, die von der erfindungsgemäßen Idee dieser Druckschrift beseitigt werden, auf. Denkbar wäre aber, dass nur ein einzelner erfindungsgemäßer Substrathalter bereits ausreicht um einen guten Bond zu erzeugen, sodass daher ein gewöhnlicher Substrathalter aus dem Stand der Technik auf der anderen Seite verwendet werden kann. Bei dem Verformungselement handelt es sich dann vorzugsweise um einen einfachen Krümmungsstift. Dieser Krümmungsstift darf nicht mit den, viel kleineren, Stiften eines Stift Substrathalters (engl.: pins chuck) verwechselt werden.

In einem **sechsten** erfindungsgemäßen Prozessschritt erfolgt die kontinuierliche, gezielte und vor allem gesteuerte Loslassung der Substrate von den Substrathaltern. Vorteilhaft ist dabei vor allem, wenn zumindest der obere Substrathalter nicht nur ein erfindungsgemäßer Substrathalter ist, sondern sich die Fixierungen an seiner Fixieroberfläche auch örtlich gezielt steuern lassen. Das ist vor allem dann möglich, wenn die Fixierungen in Zonen, insbesondere Vakuumzonen, gruppiert wurden, wie es in der Druckschrift WO2017162272A1 ausführlich offenbart wurde.

Ein wesentlicher erfindungsgemäßer Aspekt des erfindungsgemäßen Verfahrens ist daher die gezielt einstellbare Krümmung eines Substrats mit Hilfe eines erfindungsgemäßen Substrathalters, die nur deshalb möglich wird, weil keine mechanische Rückkopplung auf das Substrat erfolgt in Kombination mit einer gezielt steuerbaren Loslösung eines Substrats von seiner Fixieroberfläche während des Voranschreitens der Bondwelle.

Weitere Vorteile, Merkmale und Einzelheiten der Erfindung ergeben sich aus der nachfolgenden Beschreibung bevorzugter Ausführungsbeispiele sowie anhand der Zeichnungen. Die zeigen in:
- Figur 1a: einen Anfangszustand eines Substrathalters im Stand der Technik,
- Figur 1b: einen Endzustand eines Substrathalters im Stand der Technik,
- Figur 2a: einen Anfangszustand eines erfindungsgemäßen Substrathalters ohne Kompensationsplatte,
- Figur 2b: einen Endzustand eines erfindungsgemäßen Substrathalters ohne Kompensationsplatte,
- Figur 3a: einen Anfangszustand eines erfindungsgemäßen, erweiterten, Substrathalters mit Kompensationsplatte,
- Figur 3b: einen Endzustand eines erfindungsgemäßen, erweiterten, Substrathalters mit Kompensationsplatte,
- Figur 4: eine erste erfindungsgemäße Ausführungsform eines erfindungsgemäßen Substrathalters mit Kompensationsplatte,
- Figur 5: eine zweite erfindungsgemäße Ausführungsform eines erfindungsgemäßen Substrathalters mit Kompensationsplatte,
- Figur 6a: eine dritte, bevorzugte erfindungsgemäße Ausführungsform eines Substrathalters mit Kompensationsplatte in Seiten- und Aufsicht in einem Anfangszustand
- Figur 6b: eine dritte, bevorzugte erfindungsgemäße Ausführungsform eines Substrathalters mit Kompensationsplatte in Seitenansicht in einem Endzustand

In den Figuren werden gleiche Bauteile oder Bauteile mit der gleichen Funktion mit den gleichen Bezugszeichen gekennzeichnet.

Die beiden folgenden Figurenbeschreibungen und ihre zugehörigen Figuren, die zwei Zustände eines Substrathalters im Stand der Technik zeigen, sind so allgemein wie möglich gehalten, um das grundsätzliche Konzept zu veranschaulichen. Es handelt sich um eine möglichst einfache Beschreibung und um Prinzipskizzen, ohne den Anspruch auf Vollständigkeit.

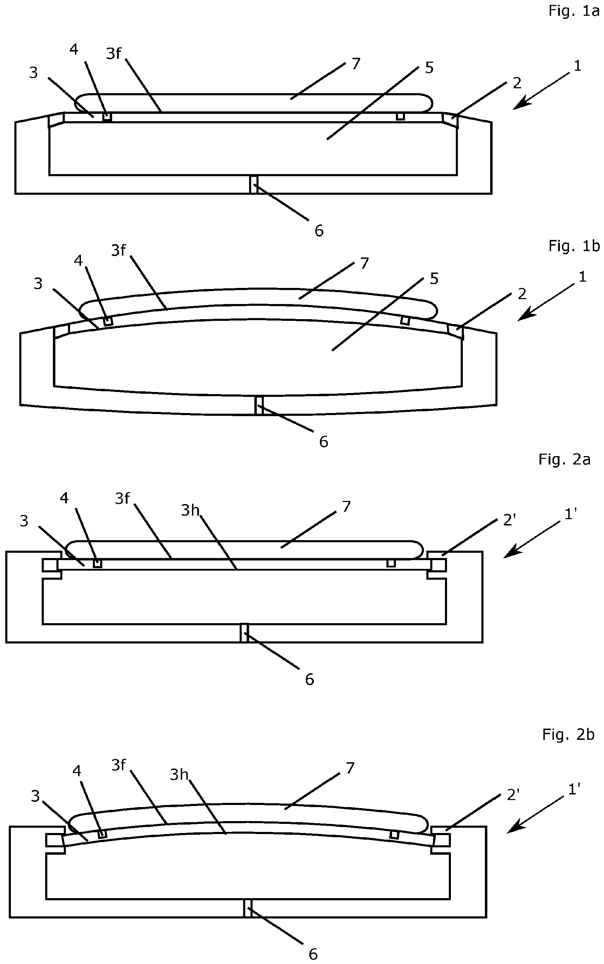

Die **Figur 1a** zeigt eine schematische Darstellung eines Anfangszustands eines Substrathalters 1 im Stand der Technik, dessen Fixierplattenoberfläche 3f gekrümmt werden kann. Der Substrathalter 1 verfügt über eine Fixierplatte 3, die insbesondere über eine Plattenlagerung 2, insbesondere an der Peripherie, gelagert werden kann. Im vorliegenden Fall handelt es sich bei der Plattenlagerung 2 vor allem um ein Festlager, das insbesondere auch nicht gelenkig ausgelegt ist. Denkbar wäre natürlich auch, dass die Fixierplatte 3 direkt mit dem Rest des Substrathalters 1 mechanisch verbunden wäre. Wichtig ist, dass es eine als Fixierplattenoberfläche 3f beschrieben Oberfläche gibt, die gekrümmt werden kann. Die Fixierplatte 3 ist daher so konstruiert und/oder gelagert, dass sie gekrümmt werden kann.

Insbesondere befinden sich Substratfixierungen 4 auf der Platte 3, mit deren Hilfe ein Substrat 7 an der Platte 3 fixiert werden kann. Wie die Substratfixierungen 4 angesteuert werden, ist für das Verständnis der Vorrichtung aus dem Stand der Technik nicht von Relevanz und wird hier nicht näher erläutert.

Die **Figur 1b** zeigt eine schematische Darstellung eines Endzustands eines Substrathalters 1 im Stand der Technik. Der Substrathalter 1 wird in diesem speziellen Fall, von außen betrachtet, konvex gekrümmt, weil im Hohlraum 5 ein Überdruck aufgebaut wird. Der Überdruck entsteht dadurch, dass über ein Stellmittel 6, im speziellen Fall eine Öffnung, ein Ventil oder eine Düse, ein Gas oder Gasgemisch mit Überdruck in Bezug zur umgebenden Atmosphäre in den Hohlraum 5 strömt. Beim Stellmittel 6 kann es sich alternativ um ein mechanisches Stellmittel handelt. Die Verwendung eines Überdrucks wird hier also nur exemplarisch beschrieben.

In diesem Zustand entstehen mehrere grundsätzliche Probleme. Das erste Problem besteht darin, dass die Krümmung der Fixierplattenoberfläche 3f, und damit auch des Substrats 7, im Allgemeinen inhomogen ist, d.h. die Krümmung ändert sich, im Allgemeinen mit dem Ort. Das ist ein, im Allgemeinen unerwünschter Zustand. Die Inhomogenität der Krümmung ist in der Figur nur schwer erkennbar. Dieses Problem hängt vor allem damit zusammen, dass die Lager 2 als Festlager konzipiert sind, d.h. die Anzahl der Freiheitsgrade zu gering oder sogar null ist.

Ein weiteres Problem im Stand der Technik sind also die Lager 2, die meistens so ausgelegt sind, dass sie Reaktionskräfte und/oder Momente auf die Fixierplatte 3 übertragen können. Insbesondere werden die Lager 2 im Stand der Technik nicht gelenkig ausgeführt. Die Lager 2 sind daher im Stand der Technik meistens in der Lage, ein Moment zu übertragen.

Ein weiteres Problem besteht darin, dass ein beliebiges Stellelement 6, welches für die Verformung der Fixierplatte 3 zuständig ist, immer eine Gegenkraft erzeugt. Verallgemeinert und physikalisch ausgedrückt entsteht gemäß dem dritten Newtonschen Axiom eine Gegenkraft, normiert auf die Fläche ein entsprechender Gegendruck, der den Substrathalter 1 in die andere Richtung biegt. Diese unerwünschte Krümmung des Substrathalters 1 wirkt insbesondere auf die Plattenlagerung 2 zurück und beeinflusst damit auch das Krümmungsverhalten der Fixierplatte 3, sowie die Krümmung des auf der Fixierplatte 3 fixierten Substrats 7.

Das hängt mit dem oben genannten Problem zusammen, dass im Stand der Technik die Plattenlagerung 2 so ausgeführt sind, dass Reaktionskräfte und/oder Momente übertragen werden können. Auch wenn sich steuerungstechnisch ein Endzustand einstellt, ist eine Rückwirkung über den Substrathalter 1 feststellbar, die absolut unerwünscht ist, da Messungen gezeigt haben, dass sich dadurch ein durchzuführendes Bondergebnis verschlechtert. Es wird explizit erwähnt und hervorgehoben, dass die genannten mechanischen Rückkopplungseffekte selbstverständlich nicht von der Art des Stellmittels 6, im vorliegenden exemplarischen Fall eine Öffnung durch die ein Gas oder ein Gasgemisch strömt, abhängt, genauso wenig wie von der Existenz eines Hohlraums 5.

Bei dem Stellmittel 6 kann es sich genauso gut um einen mechanisches Stellmittel, einen Stift, eine Piezosäule, einen Balg oder ein beliebig anderes Stellmittel handeln, welches die Fixierplatte 3 krümmen kann. In diesen Fällen würde es wahrscheinlich auch keinen entsprechenden Hohlraum 5 geben. Das grundsätzliche physikalische Gesetz verlangt immer, dass eine mechanische Rückkopplung auf den Substrathalter erfolgt.

Die folgenden Figurenbeschreibungen bzw. Figuren, die jeweils zwei Zustände von zwei erfindungsgemäßen Substrathaltern 1', 1" zeigen, sind so allgemein wie möglich gehalten, um das grundsätzliche Konzept zu veranschaulichen. Es handelt sich um eine möglichst einfache Beschreibung und um Prinzipskizzen, ohne den Anspruch auf Vollständigkeit. Die erfindungsgemäßen Ausführungsformen werden danach in weiteren Figuren genauer beschrieben.

Die erfindungsgemäße Idee wird wieder mit Hilfe einer Vorrichtung veranschaulicht, in der ein Fluid verwendet wird, um in einem Hohlraum 5 einen Überdruck zu erzeugen, der die Fixierplatte 3, auf der das Substrat 7 fixiert wird, krümmt. Es wird erneut hervorgehoben, dass die erfindungsgemäße Idee nicht an die Verwendung eines Fluids und/oder einen Hohlraum 5 gebunden ist. Genauso gut könnte der erfindungsgemäße Aspekt mit Hilfe mechanischer, pneumatischer, elektrischer, piezoelektrischer Stellmittel 6 realisiert werden, wie in speziellen Ausführungsformen später noch gezeigt und dargelegt wird.

Die **Figur 2a** zeigt eine schematische Darstellung eines Anfangszustandes eines erfindungsgemäßen Substrathalters 1' mit dem zumindest eine homogene Krümmung eingestellt werden kann. Es wird davon ausgegangen, dass der Substrathalter 1' einen so großen Biegewiderstand besitzt, dass das Problem der mechanischen Rückkopplung, dessen Eliminierung oder Reduzierung in späteren Figuren ausführlicher beschreiben wird, hier noch nicht auftritt. Eine Erhöhung des Biegewiderstands kann beispielsweise sehr einfach erreicht werden, indem man einige Bauteile des Substrathalters 1', insbesondere den Substrathalter 1' als Ganzes, dicker konstruiert. Wichtig ist die Lagerung 2', die so gefertigt ist, dass keine oder nur sehr geringe Reaktionskräfte und/oder Momente auf die Fixierplatte 3 übertragen werden. Insbesondere ist die Form der Hohlraumplattenoberfläche 3h so gewählt, dass eine spätere Krümmung der Fixierplatte 3 eine wohldefinierte, insbesondere homogene, Krümmung erzeugt.

Die **Figur 2b** zeigt eine schematische Darstellung eines Endzustandes eines erfindungsgemäßen Substratalters 1', mit dem zumindest eine homogene Krümmung eingestellt werden kann. Auch wenn der erfindungsgemäße Substrathalter 1' über einen höheren Biegewiderstand verfügt, muss er dennoch, wenn auch nur in geringem Ausmaß, bei der Verwendung eines Stellelements 6 ebenfalls leicht gekrümmt werden. Diese Krümmung ist aber auf Grund des relativ hohen Biegewiderstands relativ klein. Dennoch entstehen Kräfte und/oder Momente, die ohne die Lagerung 2' auf die Fixierplatte 3 übertragen werden würden.

Durch die spezielle Lagerung 2' kann eine noch wohldefinierte, insbesondere homogene, Krümmung an der Fixieroberfläche 3f und damit am Substrat 7 eingestellt werden, da mögliche Reaktionskräfte und/oder Momente nicht oder nur in noch geringerem Ausmaß auf die Fixierplatte 7 übertragen werden. Die Lagerung 2' unterstützt dabei die Ausbildung einer homogenen Krümmung zusätzlich zu den bereits in Massivbauweise ausgeführten Bauteilen. Im speziellen Fall wird zur Einstellung der Krümmung ein Stellmittel 6 verwendet, bei dem es sich um eine Öffnung, eine Düse oder ein Ventil handelt, durch welches ein Fluid, insbesondere eine Gasmischung, vorzugsweise Luft, gepresst wird.

Durch die Verwendung eines Fluids erlangt die erfindungsgemäße Ausführungsform mit der speziell geformten Hohlraumplattenoberfläche 3h besondere Bedeutung. Durch die Verwendung eines Fluids, welches einen homogenen und isotropen Druck auf die Hohlraumplattenoberfläche 3h ausübt, kann eine entlang der Hohlraumplattenoberfläche 3h angenommene Kraftverteilung, bei der die Kräfte immer normal auf die Hohlraumplattenoberfläche 3h stehen, angenommen werden.

Durch diese Annahme wird es besonders einfach mit Hilfe numerischer Simulationen, insbesondere finite Elemente Methoden, eine geeignete Form der Hohlraumplattenoberfläche 3f zu berechnen, um die gewünschte, insbesondere homogene, Krümmung an der Fixieroberfläche 3f, und damit am fixierten Substrat 7, zu erhalten. Eine solche spezielle Form der Hohlraumplattenoberfläche 3f verbessert die Ausbildung einer homogenen Krümmung der Fixierplattenoberfläche 3f und damit des Substrats 7 noch weiter.

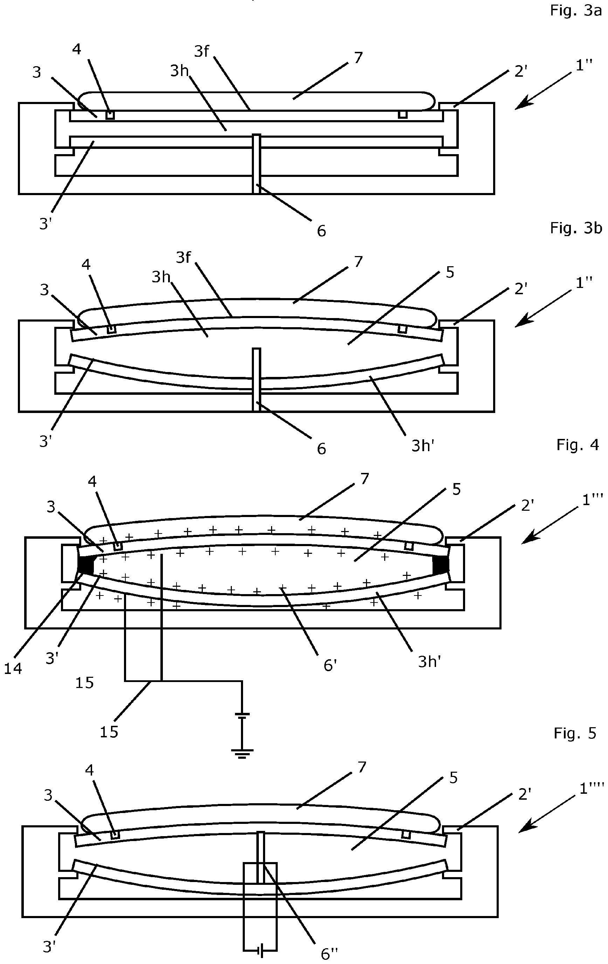

Die **Figur 3a** zeigt eine schematische Darstellung eines Anfangszustandes eines erfindungsgemäßen, weiter verbesserten, Substratalters 1" mit dem zumindest eine homogene Krümmung eingestellt werden kann und bei dem schädliche Einflüsse einer mechanischen Rückkopplung auf die Plattenhalterung 2' weiter minimiert werden kann. Eine derartige erfindungsgemäße Verbesserung ist vor allem dann vorteilhaft, wenn die Substrathalter 1" relativ dünn konstruiert wurden und einen sehr geringen Biegewiderstand besitzen.

Dann kann die mechanische Rückwirkung nicht mehr vernachlässigt werden und sollte durch die verbesserte erfindungsgemäße Ausführungsform zumindest reduziert, vorteilhafterweise gänzlich eliminiert werden. Auf die Vorteile der speziell geformten Hohlraumplattenoberfläche 3h wird hier nicht mehr eingegangen. Der Substrathalter 1" verfügt über eine Fixierplatte 3 und eine Kompensationsplatte 3' die über eine Plattenlagerung 2' gelagert werden. Die Platten 3, 3' sind dabei so konstruiert und/oder gelagert, dass sie gekrümmt werden können.

Der Vollständigkeit halber wird erwähnt, dass die Platte 3 theoretisch gesehen kein eigenes Bauteil sein muss, sondern Teil des Substrathalters 1' sein könnte. Wichtig ist nur das Vorhandensein einer Fixierplattenoberfläche 3f.

Dadurch würden sich allerdings Randbedingungen ergeben, die die Erzeugung einer konstanten Krümmung der Fixierplattenoberfläche 3f nahezu unmöglich machen. Die erfindungsgemäß bevorzugteste Ausführungsform sieht daher vor, dass die Fixierplatte 3 ein eigenständiges Bauteil darstellt. Der erfindungsgemäße Effekt besteht daher vor allem in der Verwendung einer Kompensationsplatte 3'.

Im weiteren Verlauf der Figurenbeschreibung wird daher jede erfindungsgemäße Ausführungsform mit der bevorzugten konstruktionstechnischen Lösung zweier Platten dargestellt. Insbesondere befinden sich Substratfixierungen 4 auf der Fixierplatte 3, mit deren Hilfe ein Substrat 7 an der Fixierplatte 3 fixiert werden kann. Wie die Substratfixierungen 4 angesteuert werden, ist für das Verständnis der Vorrichtung nicht von Relevanz und wird hier nicht näher erläutert. In den folgenden Figuren wird gezeigt werden, wie Substratfixierungen 4, die als Vakuumfixierungen ausgeführt sind, angesteuert werden.

Die **Figur 3b** zeigt eine schematische Darstellung eines Endzustandes des erfindungsgemäßen, weiter verbesserten, Substrathalters 1". Durch ein Stellmittel 6, im vorliegenden speziellen Fall eine Öffnung, ein Ventil oder eine Düse, wird ein Fluid in einen Hohlraum 5 gepresst, welches zu einer Krümmung der beiden Platten 3, 3' führt. Im Gegensatz zum Stand der Technik gemäß Figur 1a erfolgt keine Krümmung der Fixierung 2 oder anderen Teilen des Substrathalters 1' und damit entsteht kein zusätzliches, über die Fixierung 2 einwirkendes, Moment auf die Fixierplatte 3 und das darauf fixierte Substrat 7. Die Krümmung der Fixierplatte 3 erfolgt daher nur durch den Effekt des Stellmittels 6.

Die Kompensationsplatte 3' kann daher als eine Art "Opferplatte" angesehen werden, deren einzige Aufgabe darin besteht, die Krafteinwirkung auf die restlichen Bauteile des Substrathalters 1' zu verhindern oder zumindest zu minimieren. Im speziellen Fall müssen die Platten 3, 3', insbesondere an deren Peripherie, abgedichtet werden. Auf die Darstellung der Einzelheiten, insbesondere der Dichtung, wird auf Grund der Übersichtlichkeit in dieser Prinzipskizze verzichtet. Die Abdichtung wird in einer später dargestellten Figur der bevorzugtesten Ausführungsform allerdings noch ausführlicher behandelt.

In den weiteren Figuren werden die unterschiedlichen erfindungsgemäßen Ausführungsformen einzeln und im Detail behandelt und dargestellt.

Die **Figur 4** zeigt eine erste, bevorzugte, erfindungsgemäße Ausführungsform, bei der die beiden Platten 3, 3' auf ein elektrisches Potential mit demselben Vorzeichen, insbesondere demselben Wert, gesetzt werden. Um zu verhindern, dass die beiden Platten 3, 3' einen elektrisch leitenden, in sich geschlossenen Körper bilden, müssen die Platten 3, 3' an deren Kontaktpunkten mittels einer Elektrischen Isolation 14 voneinander elektrisch isoliert werden. Ansonsten würden gemäß den physikalischen Gesetzen alle Ladungen an den Hohlraumplattenoberfläche 3h, 3h', die den Hohlraum 5 bilden, nach außen wandern.

Der in sich geschlossenen Körper würde einen faradayschen Käfig bilden und die Speicherung von Ladung nur an der Außenseite ermöglichen. Die elektrische Isolierung 14 sorgt dafür, dass die beiden Platten 3, 3', elektrostatisch betrachtet, nicht einen in sich geschlossenen, leitfähigen Körper, sondern jeweils einen leitfähigen Körper bilden. Dadurch ist die Erzeugung von Ladungen an den Substratoberflächen, die den Hohlraum 5 bilden, möglich. Die auf den Hohlraumplattenoberfläche 3h, 3h' befindlichen Ladungen bzw. die beiden Platten 3, 3' selbst stellen, zusammen mit dem notwendigen Stromkreis 15, dementsprechend das Stellmittel 6` dar.

Die **Figur 5** zeigt eine zweite, bevorzugte, erfindungsgemäße Ausführungsform, bei der sich ein Stellmittel 6" zwischen den beiden Platten 3, 3' befindet. Bei dem Stellmittel 6" kann es sich beispielsweise um ein elektrisch und/oder pneumatisch und/oder hydraulisch ansteuerbares mechanisches Stellelement handeln. Denkbar wäre auch die Verwendung einer elektrisch ansteuerbaren Piezosäule. Bei dem Stellmittel 6" könnte es sich auch um zwei sehr starke Elektromagneten handeln, die elektrisch angesteuert zwei Magnetfelder erzeugen und sich so voneinander abstoßen, dass die beiden Platten 3, 3' auseinandergetrieben werden. Denkbar wäre auch eine Ausführungsform, bei der zwei Platten auf dasselbe elektrische Potential gesetzt werden und sich durch ihre elektrostatische Ladung abstoßen.

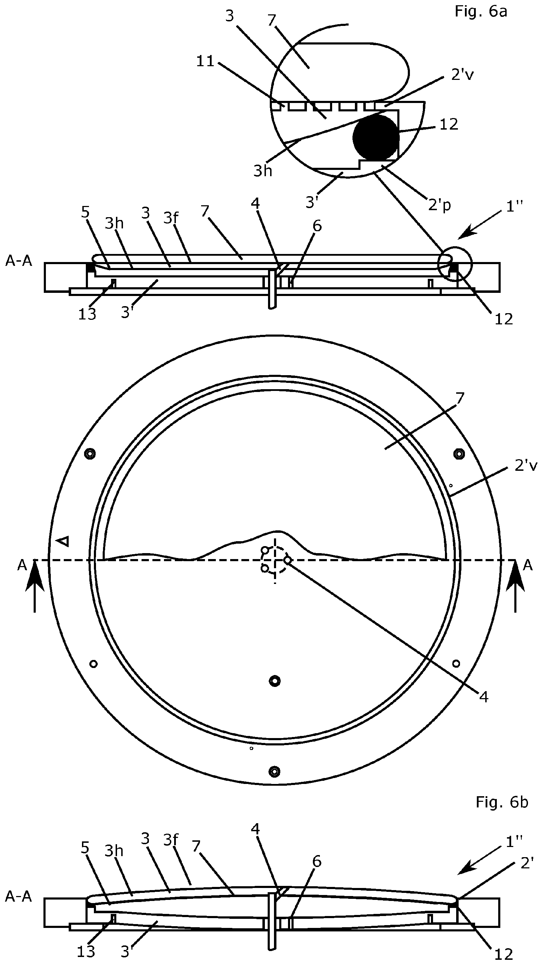

Die **Figur 6a** zeigt die dritte, bevorzugte erfindungsgemäße Ausführungsform in einer Seitenansicht, einer Detailansicht und einer Aufsicht in einem Ausgangszustand. Bei dieser erfindungsgemäßen Ausführungsform handelt es sich um eine sehr viel detaillierter beschriebene Ausführungsform aus den Figuren 3a und 3b. Die Darstellung umfasst (i) das speziell gefertigte Lager 2', über das möglichst keine oder nur sehr geringe Reaktionskräfte und/oder Momente übertragen werden können, sowie (ii) die Kompensationsplatte 3'.

Die Wichtigkeit dieser Ausführungsform beruht vor allem darauf, dass zur Krümmung der beiden Platten 3, 3' ein Fluid verwendet wird, welches aufgrund eines statischen Drucks eine isotrope, d.h. gleichmäßige Kraftwirkung auf die beiden Platten 3, 3', insbesondere aber die Fixierplatte 3 besitzt. Alle genannten Merkmale in der Figur 6a können insbesondere auch in den vorher genannten und behandelten Substrathaltern der Figuren 3 und 4 verwendet werden. Auf Grund der Wichtigkeit dieser Ausführungsform werden sie in dieser Figur allerdings genau beschrieben.

Vorzugsweise wird die Fixierplattenoberfläche 3f der Fixierplatte 3 an ihrer Peripherie über einen Plattenlagerungsvorsprung 2'v und die Plattenoberfläche 3h der Fixierplatte 3 über eine Dichtung 12 gelagert bzw. kontaktiert. Die Dichtung 12 wiederum liegt vorzugsweise auf der unteren Kompensationsplatte 3', insbesondere auf einem Plattenlagerungspodest 2'p, auf. Die Dichtung 12 dichtet die Peripherien der Platten 3, 3' gegeneinander ab und erlaubt dennoch die Krümmung beider Platten 3, 3'.

An dieser Stelle wird noch einmal erwähnt, dass die Krümmungen extrem gering, d.h. die Krümmungsradien sehr groß sind. Ein Punkt auf einer beliebigen Oberfläche einer der beiden Platten 3, 3' wird sich in z-Richtung nur um einige wenige Nanometer, Mikrometer, in den seltensten Fällen aber um Millimeter, verschieben. Derartig geringe Krümmungen gestatten es auch, eine derart filigrane Konstruktion mechanisch stabil zu halten. Insbesondere kann dadurch der Plattenlagerungsvorsprung 2`v sehr fein ausgeführt werden.

Das Substrat 7 wird durch eine Substratfixierung 4 fixiert. Im speziellen Fall zeigt die Zeichnung, dass Teile der Substratfixierung 4 durch den Hohlraum 5 reichen. Diese Teile sind insbesondere dehnbar ausgeführt. Es kann sich dabei beispielsweise um einen Schlauch, ein nachgeführtes Rohr oder jede beliebige andere Leitung handeln, die in der Lage ist, den Bereich zwischen dem Substrat 7 und der Fixierplatte 3 zu evakuieren. Insbesondere existieren mehrere Ausgangsöffnungen der Substratfixierung 3, die insbesondere symmetrisch um das Zentrum angeordnet sind. Dadurch wird es ermöglicht, dass sich im Zentrum der Fixierplatte 3 ein Pin 11 befinden kann, was sich positiv auf das Bondverhalten auswirkt.

Die **Figur 6b** zeigt die dritte, bevorzugte erfindungsgemäße Ausführungsform in einer Seitenansicht in einem Endzustand. Das Stellmittel 6, in diesem speziellen Fall eine nicht zentrische Öffnung, ein Ventil oder eine Düse, pumpt ein Fluid in den Hohlraum 5. Das Fixiersubstrat 3 wird erfindungsgemäß gekrümmt. Die Krümmung der Kompensationsplatte 3' erfolgt vorzugsweise bis zu einer Nut 13, die vollumfänglich in die Kompensationsplatte 3' eingebracht wurde.

Damit wird die Krümmung auf den zentrischen Teil der Kompensationsplatte 3' konzentriert und es wird sichergestellt, dass ein noch geringeres Moment und/oder eine noch geringe Kraft auf die Plattenlagerung 2', die in diesem Fall speziell aus einem Plattenlagerungsvorsprung 2'v, einer Dichtung 12 und einem Plattenlagerungspodest 2`p besteht (siehe Vergrößerungsansicht in der Figur 6a), mechanisch einwirkt. Durch diese weitere erfindungsgemäße konstruktionstechnische Verbesserung wird eine mechanische Rückkopplung auf die Fixierplatte 3 gänzlich verhindert bzw. so weit minimiert, dass sie vernachlässigbar ist.

### Bezugszeichenliste

- 1, 1', 1", 1‴: Substrathalter
- 2, 2': Plattenlagerung
- 2`v: Plattenlagerungsvorsprung
- 2`p: Plattenlagerungspodest
- 3: Fixierplatte
- 3': Kompensationsplatte
- 3f: Fixierplattenoberfläche
- 3h, 3h': Hohlraumplattenoberfläche
- 4: Substratfixierung
- 5: Hohlraum/Zwischenraum
- 6, 6', 6": Stellmittel/Krümmungsmittel
- 7: Substrat
- 11: Stifte (engl.: pins)
- 12: Dichtung, insbesondere Dichtring
- 13: Nut
- 14: Elektrische Isolierung
- 15: Stromkreis

## Patentansprüche

1. Substrathalter (1',1",1‴,1ʺʺ) zum Krümmen eines Substrats (7), aufweisend
- eine Fixierplatte (3) zur Befestigung des Substrats (7),
- Krümmungsmittel (6, 6', 6") zur Krümmung der Fixierplatte (3), **dadurch gekennzeichnet, dass** die Fixierplatte (3) derart ausgebildet ist, dass die Krümmung des Substrats (7) gezielt einstellbar ist, wobei die Fixierplatte (3) an ihrer Peripherie in einer Plattenlagerung (2') gelagert ist.

2. Substrathalter (1',1",1‴,1ʺʺ) nach Anspruch 1, wobei die Dicke der Fixierplatte (3) variiert.

3. Substrathalter (1',1",1‴,1ʺʺ) nach mindestens einem der vorhergehenden Ansprüche, wobei die Fixierplatte (3) gelenkig gelagert ist.

4. Substrathalter (1',1",1‴,1ʺʺ) nach mindestens einem der vorhergehenden Ansprüche, wobei eine homogene Krümmung des Substrats (7) einstellbar ist.

5. Substrathalter (1',1",1",1ʺʺ) nach mindestens einem der vorhergehenden Ansprüche, wobei die Rückseite der Fixierplatte (3) derart geformt ist, dass sich eine homogene Krümmung der Fixierplatte (3) ergibt.

6. Substrathalter (1',1",1‴,1ʺʺ) nach mindestens einem der vorhergehenden Ansprüche, wobei bei der Krümmung der Fixierplatte (3) erzeugte Reaktionskräfte durch mindestens ein Kompensationsmittel (3'), insbesondere eine krümmbare Kompensationsplatte (3'), kompensierbar sind.

7. Substrathalter (1',1",1‴,1ʺʺ) nach mindestens einem der vorhergehenden Ansprüche, wobei die Fixierplatte (3) im Zentrum dicker ist als am Rand.

8. Substrathalter (1',1",1‴,1ʺʺ) nach mindestens einem der vorhergehenden Ansprüche, wobei die Fixierplatte (3) zum Rand hin verjüngt ausgebildet ist.

9. Substrathalter (1',1",1‴,1ʺʺ) nach mindestens einem der vorhergehenden Ansprüche, wobei die Fixierplatte (3) symmetrisch zum Zentrum ausgebildet ist.

10. Vorrichtung, insbesondere Bondvorrichtung, aufweisend mindestens einen Substrathalter (1',1",1‴,1ʺʺ) gemäß mindestens einem der vorhergehenden Ansprüche.

11. Verfahren zum Bonden zweier Substrate (7), aufweisend die folgenden Schritte, wobei:
- ein erstes Substrat auf einem ersten Substrathalter (1',1",1‴,1ʺʺ) nach einem der vorhergehenden Ansprüche befestigt wird,
- ein zweites Substrat auf einem zweiten Substrathalter (1',1",1‴,1ʺʺ), insbesondere nach einem der vorhergehenden Ansprüche, befestigt wird,
- die Substrate (7) zueinander ausgerichtet werden,
- mindestens eines der Substrate (7) gekrümmt wird,
- die Substrate (7) kontaktiert werden,
**dadurch gekennzeichnet, dass** die Krümmung mindestens eines der Substrate (7) gezielt eingestellt wird.

12. Verfahren nach Anspruch 11, wobei die Krümmung mindestens eines Substrates (7) homogen eingestellt wird.
